# EUROPÄISCHE PATENTSCHRIFT

(11) **EP 2 290 820 B1**
(45) Veröffentlichungstag und Bekanntmachung des Hinweises auf die Patenterteilung: **12.06.2013**
(21) Anmeldenummer: 10170632.3
(22) Anmeldetag: 23.07.2010
(51) Int. Cl.: H03K 17/96, G06F 3/03, G06F 3/033, G06F 3/048

(54) **Verfahren zur Eingabe eines zweistelligen Wertes an einer Bedieneinrichtung**
Method for inputting a two-digit value at an operating device
Procédé de saisie d'une valeur à deux chiffres dans un dispositif de commande

(30) Priorität: 25.08.2009 DE 102009039937
(43) Veröffentlichungstag der Anmeldung: 02.03.2011
(73) Patentinhaber: E.G.O. Elektro-Gerätebau GmbH, 75038 Oberderdingen (DE)
(72) Erfinder: Fluhrer, Henry, 75015, Bretten (DE)
(74) Vertreter: Patentanwälte Ruff, Wilhelm, Beier, Dauster & Partner

(56) Entgegenhaltungen:
- EP-A1- 0 961 199
- FR-A1- 2 677 783
- US-A- 5 764 179
- US-A1- 2007 234 236

## Beschreibung

Die Erfindung betrifft ein Verfahren zur Einstellung eines zweistelligen Wertes für einen Funktionsparameter für eine Funktionseinrichtung an einer Bedieneinrichtung für die Funktionseinrichtung. Beispielsweise ist die Funktionseinrichtung eine Heizeinrichtung einer Kochstelle an einem Elektrokochfeld und die Bedieneinrichtung für das Elektrokochfeld vorgesehen.

Es ist aus dem Stand der Technik in Form beispielsweise der EP 859 467 A1 bekannt, eine Leistungsstufe einer Heizeinrichtung einer Kochstelle eines Elektrokochfeldes über zwei Berührschalter in Form von Plus- und Minus-Tasten einzustellen. Um dabei die gesamten Leistungsstufen zu durchlaufen muss entweder sehr häufig einer der Berührschalter betätigt werden. Alternativ muss mit dem Finger eine ganze Weile darauf verweilt werden. Dies wird von einer Bedienperson als wenig komfortabel empfunden.

Als Alternative dazu sind in letzter Zeit häufig Bedieneinrichtungen mit Berührsensoren in Form sogenannter Slider aufgekommen. Diese weisen ein längliches, streifenartiges Sensor-Bedienfeld auf. Durch Auflegen und Darüberstreichen mit einem Finger kann ein sehr viel schnelleres und von einer Bedienperson besser erfassbares Durchlaufen beispielsweise von Werten für eine Leistungseinstellung erfolgen.

Die FR 2 677 783 A1 beschreibt ein Verfahren zur Einstellung eines Wertes für einen Funktionsparameter auf einem Bildschirm, der als Touch-Screen ausgebildet ist. Es können die Bewegungen eines aufgelegten Fingers erkannt werden und in Steuerbefehle umgesetzt werden. Aufsetzpunkte oder Bewegungen eines Fingers können in beliebigen Richtungen erkannt und ausgewertet werden.

### Aufgabe und Lösung

Der Erfindung liegt die Aufgabe zugrunde, ein eingangs genanntes Verfahren zu schaffen, mit dem Probleme des Standes der Technik vermieden werden können und insbesondere eine komfortable, intuitive und schnelle Bedienung bzw. Einstellung eines zwei- oder mehrstelligen Wertes möglich ist.

Gelöst wird diese Aufgabe durch ein Verfahren mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Es ist vorgesehen, dass die Bedieneinrichtung ein Sensor-Bedienfeld aufweist. Dieses ist dazu ausgebildet, dass es Bewegungen eines daran angenäherten oder darauf aufgelegten Fingers in zwei Bedien-Richtungen, die im wesentlichen senkrecht zueinander sind, unabhängig voneinander erkennen und auswerten kann. Zur Einstellung eines zweistelligen Wertes wird erfindungsgemäß an der Bedieneinrichtung bzw. dem Sensor-Bedienfeld über eine Bewegung eines Fingers auf dem Sensor-Bedienfeld in eine erste Bedien-Richtung dies erkannt und dementsprechend die Einer-Stellen des Funktionswertes eingestellt. Eine Eingabe der Zehner-Stellen des Funktionswertes erfolgt unabhängig davon über eine Bewegung eines Fingers auf dem Sensor-Bedienfeld, der wiederum angenähert oder aufgelegt ist, in eine zweite Bedien-Richtung. So können die Zehner-Stellen eingestellt werden.

Dies bedeutet also, dass auf dem vorteilhaft rechteckig ausgebildeten Sensor-Bedienfeld ein Finger angenähert bzw. aufgelegt und beispielsweise nach rechts bewegt wird. Dann wird diese Richtung als erste Bedien-Richtung genommen und entsprechend der Bewegung werden die Einer-Stellen eines Funktionswertes eingestellt. Wird der angenäherte oder aufgelegte Finger in die zweite Bedien-Richtung bewegt, möglicherweise auch vor dem Einstellen der Einer-Stellen, so werden die Zehner-Stellen entsprechend eingestellt. Somit kann also mit einem einzigen Sensor-Bedienfeld ohne aufwändiges Umschalten oder Schalten in einen anderen Bedienmodus eine Eingabe bzw. Bedienung auf zwei verschiedene Arten erfolgen. Zweistellige Werte für einen Funktionsparameter wie beispielsweise eine Leistungsstufe, eine Timer-Eingabe oder sonstige Zahlenwerte können somit sehr leicht, intuitiv und schnell eingegeben werden.

Ist das Sensor-Bedienfeld in Ausgestaltung der Erfindung rechteckig, so kann die erste Bedien-Richtung der Einer-Stellen entlang einer Längsseite des Sensor-Bedienfelds verlaufen, vorteilhaft horizontal bzw. nach rechts. Die zweite Bedien-Richtung für die Zehner-Stellen verläuft dann vorteilhaft senkrecht dazu, also vertikal bzw. nach oben.

In einer Ausgestaltung der Erfindung ist es möglich, dass zu einem Zeitpunkt nur eine Stelle eingegeben werden kann, beispielsweise nur die Einer-Stellen oder nur die Zehner-Stellen. Dies bedeutet dann, dass eine Bewegung eines angenäherten bzw. aufgelegten Fingers an dem Sensor-Bedienfeld nur hinsichtlich ihrer Bewegungskomponente in eine einzige bzw. die entsprechende Bedien-Richtung berücksichtigt wird. Ein schräges Bewegen eines Fingers kann also nur hinsichtlich dieser Bewegungskomponente ausgewertet und verwendet werden, die relativ genau entlang einer der Bedien-Richtungen verläuft.

In einer Abwandlung der Erfindung kann vorgesehen sein, dass, um das Umschalten zwischen zwei Bedien-Modi zu vermeiden, bestimmte Winkelabweichungen von den Bedien-Richtungen noch als zu diesen gehörend angesehen werden. Somit kann also beispielsweise vorgesehen sein, dass eine Bewegung nach rechts entlang der ersten Bedien-Richtung nicht nur exakt nach rechts erfolgen muss, sondern auch noch in einem Winkel von beispielsweise 20° bis 25° abweichend dazu als solche erkannt werden kann, möglicherweise sogar noch mehr. Dadurch ergeben sich beispielsweise von der linken unteren Ecke des Sensor-Bedienfelds ausgehend Sektoren, die als der ersten Bedien-Richtung zugeordnet gelten. Eine Bewegung eines Fingers in diesem Sektor wird als der ersten Bedien-Richtung zugehörig gewertet. Damit kann eine etwas tolerantere Bedienung erreicht werden. Es werden also sozusagen die Bedien-Richtungen verbreitert bzw. aufgefächert.

In nochmals weiterer alternativer Abwandlung der Erfindung kann vorgesehen sein, dass eine Bewegung eines auf das Sensor-Bedienfeld aufgelegten oder daran angenäherten Fingers gleichzeitig hinsichtlich ihrer zwei Komponenten in die beiden Bedien-Richtungen ausgewertet wird und dann jeweils entsprechend dieser Richtungskomponenten die Einer-Stellen und die Zehner-Stellen verändert werden können. Dies bedeutet also, dass ein Bewegen eines Fingers ausschließlich in die erste Bedien-Richtung nur die Einer-Stellen und ausschließlich in die zweite Bedien-Richtung nur die Zehner-Stellen verstellt. Eine schräge Bewegung mit einem Winkel dazwischen verstellt beide jedoch gleichzeitig, abhängig eben vom Winkel bzw. den entsprechenden Richtungskomponenten. Damit kann also eine Bedienperson durch den gewählten Winkel der Bewegung eines Fingers zwischen den beiden Bedien-Richtungen sehr schnell, komfortabel und intuitiv einen zweistelligen Wert einstellen.

Allgemein kann vorteilhaft vorgesehen sein, ausgehend von einem Punkt, beispielsweise vorne links an dem Sensor-Bedienfeld, Bewegungen weg davon als Erhöhen des entsprechenden Wertes auszuwerten und Bewegungen darauf zu als Verringern. Alternativ zu einer Anordnung dieses wichtigen Punktes, der quasi als Start-Punkt oder Bezugs-Punkt angesehen werden kann, an einer Ecke des Sensor-Bedienfelds kann er auch in der Mitte bzw. einem Mittelbereich angeordnet werden.

Die Bedieneinrichtung bzw. das Sensor-Bedienfeld ist so ausgebildet, dass eine beliebige Bewegung eines angenäherten oder aufgelegten Fingers am Sensor-Bedienfeld oder auch nur ein Auflegepunkt erkannt werden kann. Er muss also nicht unbedingt nur in eine Richtung bewegt werden, sondern die Bewegung kann auch einen abgebogenen oder abgewinkelten Verlauf haben. Dann werden eben entsprechend einer der drei vorbeschriebenen Ausgestaltungen der Erfindung die jeweiligen zählenden Komponenten des Bedienweges berücksichtigt.

In Ausgestaltung der Erfindung kann vorgesehen sein, dass nur ein auf das Sensor-Bedienfeld aufgelegter Finger bzw. dessen Bewegung erkannt wird. Dann kann vorgesehen sein, dass bei aufgelegtem Finger ein Zurückbewegen weiterhin eine Verstellung des entsprechenden Wertes der Einer-Stellen und/oder Zehner-Stellen entsprechend der Bedien-Richtung zur Folge hat, dann möglicherweise wieder ein Verringern. Erst ein Abnehmen des Fingers beendet sozusagen die Verstellung des Wertes und bei erneutem Auflegen des Fingers kann der Wert erneut verstellt werden.

In einem grundsätzlich alternativen erfindungsgemäßen Verfahren erkennt das Sensor-Bedienfeld den Berührpunkt eines aufgelegten Fingers ohne Bewegung auf dem Sensor-Bedienfeld. Mit der Maßgabe, der Finger wäre von einem Start-Punkt aus direkt mit einer auf das Sensor-Bedienfeld aufgelegten ziehenden Bewegung darauf zu als Berührweg bewegt worden, ermittelt es am Berührpunkt Werte für die Einer-Stellen und die Zehner-Stellen und stellt diese ein, wobei diese Werte dem Berührweg entsprechen, obwohl nur ein Punkt berührt worden ist. Es ergibt sich also dasselbe Ergebnis unabhängig davon, ob der Finger am Start-Punkt auf das Sensor-Bedienfeld aufgelegt und dann zum Berührpunkt bewegt worden wäre oder der Finger direkt auf den Berührpunkt gelegt wird. Dies entspricht am ehesten einem Sensor-Bedienfeld und einer Auswertung gemäß der eingangs genannten dritten Abwandlung, bei der bei jeder Bewegung die Komponenten in die jeweilige Richtung vollständig berücksichtigt und ausgewertet werden.

Die Bedieneinrichtung kann unterschiedlich ausgebildete Sensoren aufweisen, wobei vorteilhaft mindestens in jedem Eckbereich ein Sensor angeordnet ist. Besonders vorteilhaft sind dabei auch dazwischen bzw. über die Fläche des Sensor-Bedienfelds verteilt mehrere Sensoren vorgesehen. Als Sensoren können in einer Ausgestaltung der Erfindung Drucksensoren verwendet werden, die also den durch das Auflegen eines Fingers auf das Sensor-Bedienfeld ausgeübten Druck erfassen. Hier bieten sich insbesondere Piezo-Sensoren bzw. Piezo-Resistivsensoren an. In einer anderen Ausgestaltung können kapazitive Sensoren verwendet werden, wie sie beispielsweise aus der vorgenannten EP 859 467 A1 bekannt sind. Dabei ist dann eine Deckfläche des Sensor-Bedienfelds vorteilhaft elektrisch isolierend ausgebildet, insbesondere aus Glas oder Kunststoff.

In einer nochmals weiteren Ausgestaltung können optische Sensoren verwendet werden, wobei dann eine Deckfläche des Sensor-Bedienfelds optisch durchlässig bzw. lichtdurchlässig ist. Dies sollte zumindest für Licht in einer bestimmten Wellenlänge gelten, welche die Arbeits-Wellenlänge der Sensoren ist.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: Eine Draufsicht auf eine erfindungsgemäße Bedieneinrich- tung mit Darstellung einer ersten Variante eines erfindungs- gemäßen Bedienverfahrens,
- Fig. 2: eine Draufsicht auf eine Abwandlung von Bedieneinrichtung und Bedienverfahren ähnlich Fig. 1,
- Fig. 3: eine Ansicht einer Bedieneinrichtung von unten und von der Seite mit vier Drucksensoren in Ecken des Sensor-Bedien- felds und
- Fig. 4: eine Abwandlung der Darstellung aus Fig. 3 mit kapazitiven Sensoren.

### Detaillierte Beschreibung der Ausführungsbeispiele

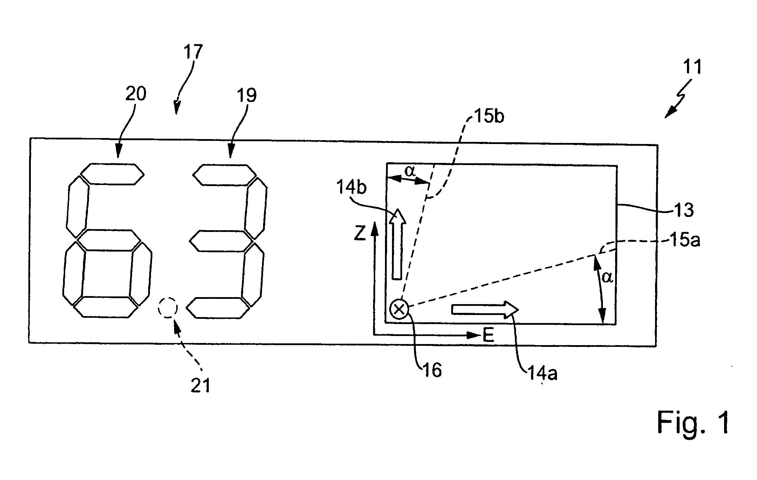

In Fig. 1 in Draufsicht eine erfindungsgemäße Bedieneinrichtung 11 dargestellt, welche in etwa rechteckig ausgebildet ist und an oder in ein Elektrogerät zu dessen Bedienung eingebaut sein kann, beispielsweise eine Dunstabzugshaube, ein Kochfeld oder einen Backofen. Die Bedieneinrichtung 11 weist im rechten Bereich ein Sensor-Bedienfeld 13 auf mit rechteckiger Form. Dieses kann ein Teil der sonstigen Oberfläche der Bedieneinrichtung 11 sein oder aber eine eigene Oberfläche aufweisen, je nach Ausgestaltung und designerischen Ansprüchen. Im linken Bereich der Bedieneinrichtung 11 ist eine Anzeige 17 vorgesehen nach Art einer Sieben-Segment-Anzeige. Die zweistellige Anzeige 17 besteht aus einer Einer-Stelle 19 und einer Zehner-Stelle 20, die durch eine gepunktet dargestellte Punkt-Anzeige getrennt sein können. Die Anzeige 17 dient erkennbar zur Anzeige eines Zahlenwertes, der zweistellig sein kann. An dieser Anzeige 17 kann eben ein bis zu zweistelliger Wert für einen Funktionsparameter einer Funktionseinrichtung des mit der Bedieneinrichtung 11 versehenen Elektrogerätes angezeigt werden, der zuvor über das Sensor-Bedienfeld 13 eingegeben worden ist. Dies können beispielsweise bei einer Dunstabzugshaube verschiedene Leistungsstufen für deren Lüfter und Helligkeitsstufen für deren Beleuchtung sein. Bei einem für beliebige Elektrogeräte verwendbaren Timer kann es eine Zeit in Minuten sein. Dabei kann der genannte zweistellige Wert durchaus so sein, dass die Einer-Stelle 19 sozusagen nach dem Komma zählt, welches durch die leuchtende Punkt-Anzeige 21 dargestellt wird, und die Zehner-Stelle 20 die Vor-Komma-Stelle ist. Weitere mögliche Werte sind Leistungsstufen an einer Kochstelle eines Elektrokochfeldes.

Dabei zeigt die Anzeige 17 den eingestellten Wert an, der über das Sensor-Bedienfeld 13 in eine Steuerung eingegeben worden ist. Diese Steuerung ist für den Fachmann leicht zu realisieren und deswegen hier nicht separat dargestellt.

Im Sensor-Bedienfeld 13 gibt es eine erste Bedien-Richtung 14a nach rechts entsprechend der Richtung E. Mit dieser ersten Bedien-Richtung 14a entsprechend der Richtung E kann die Einer-Stelle 19 des einzugebenden oder einzustellenden Wertes verändert bzw. eingestellt werden. Durch Annähern oder vorteilhaft Auflegen eines Fingers auf die Oberfläche des Sensor-Bedienfelds 13 und Bewegen entlang der Bedien-Richtung 14a wird die Einer-Stelle 19 erhöht. Dabei kann vorgesehen sein, dass in der linken unteren Ecke des Sensor-Bedienfelds 13 ein Start-Punkt 16 vorgesehen ist, möglicherweise sogar durch einen Aufdruck dargestellt ist. Wird ein Finger hier auf diesen Start-Punkt 16 aufgelegt und dann entsprechend der ersten Bedien-Richtung 14a in Richtung E bis zum rechten Rand des Sensor-Bedienfelds 13 gezogen, so kann entweder die gesamte Breite von 0 bis 9 an der Einer-Stelle 19 eingestellt werden. Für eine feinere bzw. andere Auflösung kann vorgesehen sein, dass ein Bewegen entlang der gesamten Breite des Sensor-Bedienfelds 13 nur drei bis fünf Stellen durchfährt, also für das Einstellen einer "9" als maximale Einer-Stelle 19 zweimal der Finger entlang der ersten Bedien-Richtung 14a vom Start-Punkt 16 ganz nach rechts gezogen werden muss.

Des weiteren ist eine zweite Bedien-Richtung 14b entlang der Richtung Z dargestellt, also senkrecht zur ersten Bedien-Richtung 14a. Damit kann in entsprechender, vorbeschriebener Weise die Zehner-Stelle 20 an der Anzeige 17 eingestellt werden.

Falls eine Bewegung eines Fingers nicht ganz exakt entlang der Richtungen E oder Z erfolgen soll, können Sektorenbegrenzungen 15a und 15b in gestrichelter Form vorgesehen sein, zumindest funktional und nicht unbedingt optisch erkennbar. Diese haben die Bedeutung, dass eine Bewegung eines aufgelegten Fingers innerhalb dieser Sektorenbegrenzungen 15 so gewertet wird, als ob die Bewegung genau in eine der Richtungen E oder Z als Bedien-Richtung 14 erfolgen würde. Es kann also eine tolerantere und somit einfachere Bedienung bzw. Eingabe eines Wertes erfolgen. Der Winkel α für die Sektorenbegrenzungen 15a und 15b kann beispielsweise die dargestellten 15° betragen, möglicherweise aber auch mehr als 25° oder sogar bis zu 45°. Dadurch wird dann das Sensor-Bedienfeld 13 genau in zwei Teile bzw. Sektoren geteilt, was die Bedienung noch toleranter macht.

Aus der Fig. 1 ist auch zu erkennen, dass, insbesondere wenn die Sektorenbegrenzungen 15a und 15b vorgesehen sind, eigentlich zu einem Zeitpunkt jeweils nur eine Stelle des Wertes an der Anzeige 17 eingestellt werden kann, also entweder nur die Einer-Stelle 19 oder nur die Zehner-Stelle 20. Dies ermöglicht zwar durch die Trennung eine einfache, präzise und komfortable Einstellung des Wertes. Es müssen aber zwei Bewegungen erfolgen für beide Stellen.

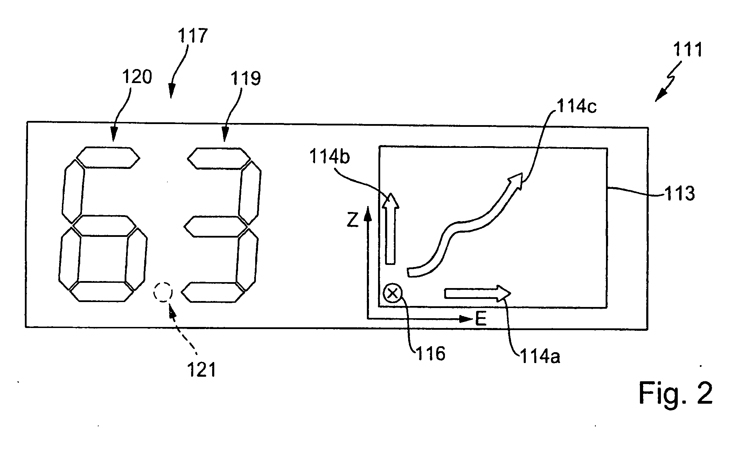

In einer anderen Ausgestaltung der Erfindung gemäß Fig. 2 soll die Einstellung des Wertes schneller bzw. unter Umständen sogar nur mit einer Bewegung vorgenommen werden können. Dabei weist diese Bedieneinrichtung 111 ein gleich aufgebautes Sensor-Bedienfeld 113 auf mit erster Bedien-Richtung 114a entlang einer Richtung E für die Einer-Stellen und mit zweiter Bedien-Richtung 114b entlang einer Richtung Z für die Zehner-Stellen. Eine Anzeige 117 weist entsprechend Fig. 1 eine Einer-Stelle 119, eine Zehner-Stelle 120 und eine gepunktet dargestellte Punkt-Anzeige 121 auf.

Hier ist vorgesehen, dass eine Bewegung eines auf das Sensor-Bedienfeld 113 aufgelegten Fingers stets in ihre Bedien-Richtungskomponenten entsprechend der Richtung E oder der Richtung Z bzw. der ersten Bedien-Richtung 114a oder der zweiten Bedien-Richtung 114b aufgeteilt wird. Dabei werden beide Stellen der Anzeige 117 bzw. beide Stellen des entsprechenden Wertes gleichzeitig verstellt.

Anhand der Bedien-Richtung 114c, sozusagen in Schlangenlinien, kann dies verdeutlicht werden. Hierbei wird bei dieser Bewegung jeweils die Komponente in Richtung E und in Richtung Z ausgewertet und dann entsprechend der Wert verändert, der an der Anzeige 117 dargestellt wird. Es wird also in einem ersten, steileren Bereich mit einer größeren Komponente in Richtung Z die Zehner-Stelle 120 stärker verstellt als die Einer-Stelle 119. Dann kommt einer flacherer Abschnitt, so dass hier wiederum die Einer-Stelle 119 stärker verstellt bzw. erhöht wird.

Die Verwendung der Begriffe "erster" und "zweiter" für die Bedien-Richtungen ist nicht auf die zeitliche Abfolge von deren Einstellung bezogen, sondern auf die Ausrichtung dieser Bedien-Richtungen entsprechend der Richtung E oder der Richtung Z, senkrecht dazu.

Für den Start-Punkt 16 kann des weiteren gelten, dass dieser dann funktional in die linke untere Ecke des Sensor-Bedienfelds 14 gesetzt wird, wenn der einzustellende Wert entsprechend der Anzeige 17 noch Null beträgt bzw. eigentlich nur erhöht werden kann. Ist ein bestimmter Wert eingestellt, der im weiteren Verlauf des Bedienverfahrens möglicherweise reduziert werden soll, wenn es beispielsweise eine Leistungsstufe einer vorgenannten Kochstelle an einem Kochfeld ist, so kann der Start-Punkt 16 auch an anderer Stelle liegen, beispielsweise in der Mitte des Sensor-Bedienfelds 13. Dies bietet den Vorteil, dass von diesem Punkt aus sowohl ein Erhöhen als auch ein Reduzieren möglich ist.

Aus Fig. 2 ist auch zu erkennen, dass weiterhin mit Bewegen eines Fingers genau entlang der ersten oder zweiten Bedien-Richtung 114a oder 114b genau nur die entsprechende Einer-Stelle 119 oder Zehner-Stelle 120 verstellt werden kann.

Angesichts der vorherigen Ausführungen zu der Toleranzerhöhung durch Verbreiterung mittels der Sektoren durch die Sektorenbegrenzungen 15 kann vorgesehen sein, dass bei einer beliebigen Bewegung auf dem Sensor-Bedienfeld 113 nicht jede noch so kleine Komponente in die zugeordnete Richtung gewertet wird, sondern nur, wenn diese beispielsweise ähnlich wie die Sektorenbegrenzung um 10° bis 15° oder sogar 20° von der reinen Richtung E oder Z abweicht.

In nochmals weiterer Ausgestaltung der Erfindung kann auch vorgesehen sein, dass nicht die Längsbewegung des Fingers auf dem Sensor-Bedienfeld 113 alleine eine Einstellung eines Wertes ermöglicht, sondern durch Auflegen des Fingers relativ weit rechts unten auf dem Sensor-Bedienfeld die Einer-Stelle 19 so stark hochgestellt wird, wie wenn der Finger durch eine aufgelegte und ziehende Bewegung in gerader Richtung an diese Stelle bewegt worden wäre.

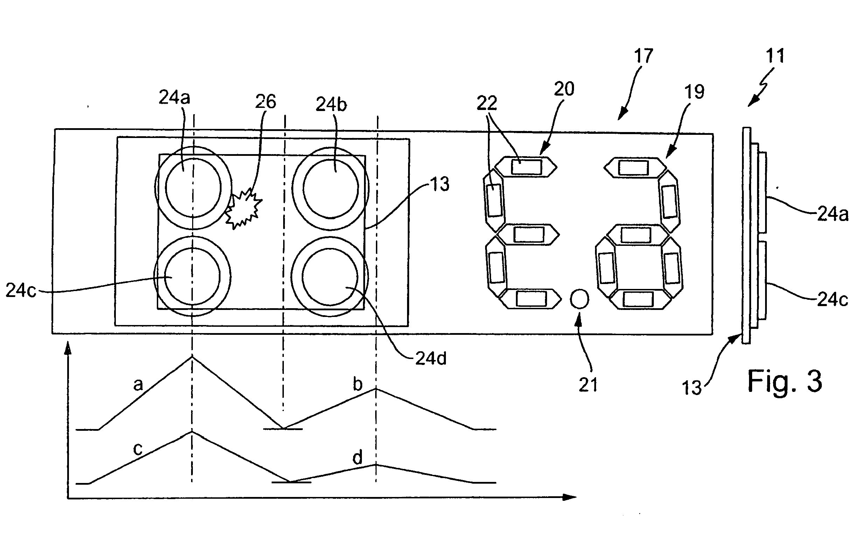

In Fig. 3 ist durch eine Rückansicht, eine Schnittdarstellung sowie ein Diagramm zum Signalhub über dem Berührweg für die Bedieneinrichtung 11 dargestellt, wie diese aufgebaut sein kann. Hierzu wird explizit auf die DE 10 2008 033 369 A1 verwiesen bzgl. des mechanischen Aufbaus mit Piezo-Sensoren 24a bis 24d unter dem Sensor-Bedienfeld 13. Diese Piezo-Sensoren 24a bis 24d sind in den vier Eckbereichen des Sensor-Bedienfelds 13 angeordnet.

Ist ein Finger von dem Start-Punkt 16 aus bis zu einem Berührpunkt 26 bewegt worden, so ist über das untere Diagramm dargestellt, wie an diesem Berührpunkt 26 bzw. auch an jedem beliebigen Berührpunkt dessen Position auf dem Sensor-Bedienfeld 13 erfasst werden kann. Hier ist in dem Diagramm dargestellt, wie sich der Signalhub der Piezo-Sensoren 24a bis 24d dementsprechend verändert, wenn der Berührpunkt 26 in ihrer Nähe liegt. Dies bedeutet also, dass über das Verhältnis der vier einzelnen Signalpegel an den Piezo-Sensoren 24 bzw. des jeweiligen Signalhubs, der am Piezo-Sensor 24a am größten ist und am Piezo-Sensor 24d am kleinsten, in etwa die Stelle auf dem Sensor-Bedienfeld 13 ermittelt werden kann. Dies ist aber an sich bekannt, siehe beispielsweise die vorgenannte DE 10 2008 033 369 A1. Über das Verfolgen der Berührpunkte 26 vom Start-Punkt 16 ausgehend kann also eine Linie bzw. Bewegung entsprechend einer Bedien-Richtung 14 nach Fig. 1 oder 114 nach Fig. 2 im zeitlichen Verlauf ermittelt werden.

Alternativ dazu kann im Rahmen der Erfindung aber auch nur der Berührpunkt 26 wie ein Endpunkt einer solchen Bewegung ermittelt werden. Wird ein Finger also ohne ziehende Bewegung auf den Berührpunkt 26 gelegt, so wird angenommen, er wäre von dem Start-Punkt 16 aus direkt mit einer aufgelegten ziehenden Bewegung darauf bewegt worden. Es werden also beim Berührpunkt 26 Werte für die Einer-Stellen und die Zehner-Stellen eingestellt, die dem Berührweg entsprechen, obwohl nur ein Punkt berührt worden ist.

Aus der Rückansicht in Fig. 3 ist auch zu erkennen, dass LED 22 für die Anzeige 17 mit Einer-Stellen 19, Zehner-Stellen 20 und der Punkt-Anzeige 21 vorgesehen sind. Dies braucht nicht näher erläutert zu werden, da es für den Fachmann klar ist.

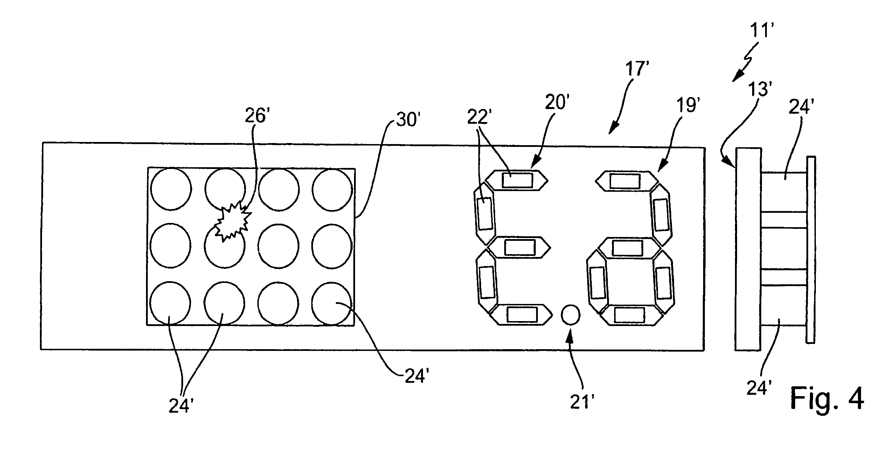

Aus der Abwandlung einer Bedieneinrichtung 11' gemäß Fig. 4 ist zu erkennen, dass hier keine Piezo-Sensoren vorgesehen sind, die auf tatsächlichen Druck und eine geringe mechanische Bewegung am Sensor-Bedienfeld reagieren, sondern zwölf kapazitive Sensorelemente 24'. Diese entsprechen den Sensorelementen aus der eingangs genannten EP 859 467 A1, weswegen für ihre Funktion darauf verwiesen wird. Dadurch ist es auch möglich, wie rechts dargestellt ist, dass das Sensor-Bedienfeld 13' erheblich dicker ausgebildet ist, beispielsweise aus Glaskeramik bestehen kann für ein Glaskeramik-Kochfeld, oder aus einem anderen elektrisch isolierenden Material. Auch hier erfolgt eine Auswertung am Berührpunkt 26' über Vergleich bzw. Verhältnis der Einzelsignalpegel der verschiedenen Sensorelemente 24'. So ist eine gute Lokalisation möglich.

Es fällt auf, dass erheblich mehr kapazitive Sensorelemente 24' vorgesehen sind als Piezo-Sensoren 24 entsprechend Fig. 3. Dadurch kann eine möglicherweise genauere Lokalisation erfolgen. Des weiteren wird dadurch dem Umstand Rechnung getragen, dass üblicherweise die örtliche Auflösung solcher kapazitiver Sensoren schlechter ist als von Piezo-Sensoren.

Werden die eingangs genannten optischen Sensoren verwendet, beispielsweise als Reflex-Lichtschranken, so können diese üblicherweise nur einen relativ engen Bereich über sich erfassen. Vor allem können sie auch nur schlecht Abstufungen erkennen, im Wesentlichen erfolgt eine Abschattung oder eben nicht. Deswegen müssten möglicherweise noch mehr solcher optischen Sensoren als kapazitive Sensorelemente vorgesehen sein, um eine ausreichend gute Auflösung zu erreichen. Deswegen werden optische Sensoren als wenig interessant angesehen.

## Patentansprüche

1. Verfahren zur Einstellung eines zweistelligen Wertes für einen Funktionsparameter für eine Funktionseinrichtung an einer Bedieneinrichtung (11, 111), wobei die Bedieneinrichtung für die Bedienung der Funktionseinrichtung ausgebildet und vorgesehen ist, wobei die Bedieneinrichtung ein Sensor-Bedienfeld (13, 113) aufweist, wobei das Sensor-Bedienfeld Bewegungen eines angenäherten oder aufgelegten Fingers in zwei Bedien-Richtungen (14a, 14b, 114a, 114b) im Wesentlichen senkrecht zueinander unabhängig voneinander erkennt und auswertet, **dadurch gekennzeichnet, dass** zur Einstellung des zweistelligen Wertes an der Bedieneinrichtung (11, 111) die Einstellung der Einer-Stellen (19, 119) über eine Bewegung eines Fingers auf dem Sensor-Bedienfeld in eine erste Bedien-Richtung (14a, 114a) erfolgt und die Einstellung der Zehner-Stellen (20, 120) unabhängig davon über eine Bewegung eines Fingers auf dem Sensor-Bedienfeld (13, 113) in die zweite Bedien-Richtung (14b, 114b).

2. Verfahren nach Anspruch 1, **dadurch gekennzeichnet, dass** das Sensor-Bedienfeld (13, 113) rechteckig ist und die erste Bedien-Richtung (14a, 114a) entlang einer Längsseite des Sensor-Bedienfelds verläuft und die zweite Bedien-Richtung (14b, 114b) im Wesentlichen senkrecht dazu, wobei vorzugsweise die Einer-Stellen (19, 119) in horizontaler Richtung als erste Bedien-Richtung und die Zehner-Stellen (20, 120) in vertikaler Richtung dazu als zweite Bedien-Richtung eingestellt werden.

3. Verfahren nach Anspruch 1 oder 2, **dadurch gekennzeichnet, dass** eine Bewegung eines auf das Sensor-Bedienfeld (13, 113) aufgelegten Fingers gleichzeitig in die beiden zwei Bedien-Richtungen (14a, 14b, 114a, 114b), vorzugsweise mit einem Winkel schräg zwischen den beiden Bedien-Richtungen, zu einem Zeitpunkt nur die Einer-Stellen (19, 119) oder nur die Zehner-Stellen (20, 120) einstellt mit dem Anteil der jeweiligen entsprechenden Bedien-Richtungskomponente an der Gesamtbewegung des Fingers, wobei nur der Anteil der exakt der Bedien-Richtung entsprechende Teil der Bedien-Richtungskomponente verwendet wird.

4. Verfahren nach Anspruch 1 oder 2, **dadurch gekennzeichnet, dass** eine Bewegung eines auf das Sensor-Bedienfeld (13, 113) aufgelegten Fingers gleichzeitig in die beiden zwei Bedien-Richtungen (14a, 14b, 114a, 114b), vorzugsweise mit einem Winkel schräg zwischen den beiden Bedien-Richtungen, nur die Einer-Stellen (19, 119) oder nur die Zehner-Stellen (20, 120) zu einem Zeitpunkt einstellt mit dem Anteil der jeweiligen entsprechenden Bedien-Richtungskomponente an der Gesamtbewegung des Fingers, wobei der mit einer Winkelabweichung von 25° oder bis zu 45° von der Bedien-Richtung abweichende Anteil der Bedien-Richtungskomponente verwendet wird.

5. Verfahren nach Anspruch 1 oder 2, **dadurch gekennzeichnet, dass** eine Bewegung eines auf das Sensor-Bedienfeld (13, 113) aufgelegten Fingers gleichzeitig in die beiden zwei Bedien-Richtungen (14a, 14b, 114a, 114b), vorzugsweise mit einem Winkel schräg zwischen den beiden Bedien-Richtungen, sowohl die Einer-Stellen (19, 119) als auch die Zehner-Stellen (20, 120) gleichzeitig einstellt mit dem Anteil der jeweiligen Bedien-Richtungskomponenten an der Gesamtbewegung des Fingers.

6. Verfahren nach einem der vorhergehenden Ansprüche, **dadurch gekennzeichnet, dass** ausgehend von einem Punkt, vorzugsweise vorne links an dem Sensor-Bedienfeld (13, 113) oder in dessen Mittelbereich, Bewegungen weg davon als Erhöhen des entsprechenden Wertes gewertet werden und Bewegungen darauf zu als Verringern so dass dieser Punkt einen Start-Punkt (16, 116) bzw. Bezugs-Punkt bildet.

## Claims

1. A method for setting a two-digit value for a function parameter for a function device at an operating device (11, 111), the operating device being designed and intended for operating the function device, the operating device having a sensor operating panel (13, 113), the sensor operating panel detecting and evaluating movements of a finger in proximity or in contact in two operating directions (14a, 14b, 114a, 114b) substantially perpendicular to one another, independently of one another,
**characterized in that**
setting of the two-digit value at the operating device (11, 111) is achieved for the units places (19, 119) by a movement of a finger on the sensor operating panel in a first operating direction (14a, 114a) and for the tens places (20, 120) independently of this by a movement of a finger on the sensor operating panel (13, 113) in a second operating direction (14b, 114b).

2. The method according to claim 1, **characterized in that** the sensor operating panel (13, 113) is rectangular and the first operating direction (14a, 114a) passes along a longitudinal side of the sensor operating panel and the second operating direction (14b, 114b) substantially vertical thereto, where the units places (19, 119) are preferably set in the horizontal direction as the first operating direction and the tens places (20, 120) in the vertical direction thereto as the second operating direction.

3. The method according to claim 1 or 2, **characterized in that** a movement of a finger in contact with the sensor operating panel (13, 113) simultaneously in both the two operating directions (14a, 14b, 114a, 114b), preferably at an angle obliquely between the two operating directions, adjusts only the units places (19, 119) or only the tens places (20, 120) at a time with the proportion of the respective corresponding operating direction component of the overall movement of the finger, where only the proportion of that part of the operating direction component corresponding precisely to the operating direction is used.

4. The method according to claim 1 or 2, **characterized in that** a movement of a finger in contact with the sensor operating panel (13, 113) simultaneously in both the two operating directions (14a, 14b, 114a, 114b), preferably at an angle obliquely between the two operating directions, adjusts only the units places (19, 119) or only the tens places (20, 120) at a time with the proportion of the respective corresponding operating direction component of the overall movement of the finger, where the proportion of the operating direction component diverging from the operating direction by a diverging angle of 25° or up to 45° is used.

5. The method according to claim 1 or 2, **characterized in that** a movement of a finger in contact with the sensor operating panel (13, 113) simultaneously in both the two operating directions (14a, 14b, 114a, 114b), preferably at an angle obliquely between the two operating directions, adjusts both the units places (19, 119) and the tens places (20, 120) at the same time with the proportion of the respective operating direction components of the overall movement of the finger.

6. The method according to any of the preceding claims, **characterized in that** starting from one point, preferably front left of the sensor operating panel (13, 113) or in its central area, movements away from it are evaluated as an increase in the corresponding value and movements toward it as a decrease, such that this point forms a starting point (16, 116) or reference point.

## Revendications

1. Procédé de réglage sur un dispositif de commande (11, 111) d'une valeur à deux chiffres pour un paramètre de fonction destiné à un dispositif fonctionnel, dans lequel le dispositif de commande est conçu et prévu pour la commande du dispositif fonctionnel, dans lequel le dispositif de commande comporte un panneau de commande à capteurs (13, 113), dans lequel le panneau de commande à capteurs détecte et évalue des mouvements d'un doigt situé à proximité ou appliqué dans deux directions de fonctionnement (14a, 14b, 114a, 114b) sensiblement perpendiculaires l'une à l'autre et indépendantes l'une de l'autre, **caractérisé en ce que** pour régler la valeur à deux chiffres sur le dispositif de commande (11, 111), le réglage des chiffres des unités (19, 119) s'effectue par l'intermédiaire d'un mouvement d'un doigt sur le panneau de commande à capteurs dans une première direction de fonctionnement (14a, 114a) et le réglage des chiffres des dizaines (20, 120) s'effectue indépendamment de cela par l'intermédiaire d'un mouvement d'un doigt sur le panneau de commande à capteurs (13, 113) dans la seconde direction de fonctionnement (14b, 114b).

2. Procédé selon la revendication 1, **caractérisé en ce que** le panneau de commande à capteurs (13, 113) est rectangulaire et **en ce que** la première direction de fonctionnement (14a, 114a) s'étend le long d'un côté longitudinal du panneau de commande à capteurs et la seconde direction de fonctionnement (14b, 114b) est sensiblement perpendiculaire à celle-ci, dans lequel les chiffres des unités (19, 119) sont de préférence réglés dans la direction horizontale en tant que première direction de fonctionnement et les chiffres des dizaines (20, 120) sont réglés dans la direction verticale par rapport à celle-ci en tant que seconde direction de fonctionnement.

3. Procédé selon la revendication 1 ou 2, **caractérisé en ce qu'**un mouvement d'un doigt appliqué sur le panneau de commande à capteurs (13, 113) ne règle simultanément que les chiffres des unités (19, 119) ou que les chiffres des dizaines (20, 120) en un point dans le temps dans les deux directions de fonctionnement (14a, 14b, 114a, 114b), de préférence de manière inclinée d'un angle formé entre les deux directions de fonctionnement, proportionnellement à la composante de direction de fonctionnement correspondante respective par rapport au mouvement total du doigt, dans lequel seule la proportion de la fraction correspondant exactement à la direction de fonctionnement de la composante de direction de fonctionnement est utilisée.

4. Procédé selon la revendication 1 ou 2, **caractérisé en ce qu'**un mouvement d'un doigt appliqué sur le panneau de commande à capteurs (13, 113) ne règle simultanément que les chiffres des unités (19, 119) ou que les chiffres des dizaines (20, 120) en un point dans le temps dans les deux directions de fonctionnement (14a, 14b, 114a, 114b), de préférence de manière inclinée d'un angle formé entre les deux directions de fonctionnement, proportionnellement à la composante de direction de fonctionnement correspondante respective par rapport au mouvement total du doigt, dans lequel la proportion de la composante de direction de fonctionnement qui s'écarte d'un écart angulaire de 25° ou allant jusqu'à 45° de la direction de fonctionnement est utilisée.

5. Procédé selon la revendication 1 ou 2, **caractérisé en ce qu'**un mouvement d'un doigt appliqué sur le panneau de commande à capteurs (13, 113) règle simultanément aussi bien les chiffres des unités (19, 119) que les chiffres des dizaines (20, 120) dans les deux directions de fonctionnement (14a, 14b, 114a, 114b), de préférence de manière inclinée d'un angle formé entre les deux directions de fonctionnement, proportionnellement aux composantes de direction de fonctionnement respectives par rapport au mouvement total du doigt.

6. Procédé selon l'une quelconque des revendications précédentes, **caractérisé en ce qu'**à partir d'un point, de préférence dans la zone avant gauche du panneau de commande à capteurs (13, 113) ou dans sa zone médiane, des mouvements d'écartement par rapport à celui-ci sont évalués comme étant des augmentations de la valeur correspondante et des mouvements de rapprochement vers celui-ci sont évalués comme étant des diminutions, de sorte que ce point forme un point de départ (16, 116) ou un point de référence.
